# EUROPEAN PATENT APPLICATION

(11) **EP 4 672 927 A1**
(43) Date of publication of application: **31.12.2025**
(21) Application number: 24787975.2
(22) Date of filing: 04.04.2024
(51) Int. Cl.: H10K 30/10, H10K 30/81, H10K 30/88, H10K 85/50

(54) **INTERNAL SERIES-CONNECTED PEROVSKITE SOLAR CELL MODULE AND PREPARATION METHOD THEREFOR**

(30) Priority: 10.04.2023 CN 202310410838
(71) Applicant: Quzhou Microquanta Renewable Energy Techn. Co., Ltd., Quzhou, Zhejiang 324022 (CN)
(72) Inventor: YAO, Jizhong, Quzhou, Zhejiang 324022 (CN); YAN, Buyi, Quzhou, Zhejiang 324022 (CN); ZHU, Jiquan, Quzhou, Zhejiang 324022 (CN); DAI, Wanlei, Quzhou, Zhejiang 324022 (CN); YANG, Yawen, Quzhou, Zhejiang 324022 (CN)
(74) Representative: Dai, Simin
(86) International application number: PCT/CN2024/086163
(87) International publication number: WO 2024/212872

(57) **Abstract**

An internal series-connected perovskite solar cell module and a preparation method therefor. The perovskite solar cell module comprises a plurality of longitudinally arranged battery sub-packs (1); each battery sub-pack (1) comprises a positive electrode lead-out section (3), a negative electrode lead-out section (4) and a plurality of battery cells (5) which are transversely arranged; and the internal structures of the positive electrode lead-out section (3), the negative electrode lead-out section (4) and the plurality of battery cells (5) respectively comprise, from bottom to top, a substrate (51), a front electrode layer (52), a light absorption layer (53) and a rear electrode layer (54). According to the present invention, the rear electrode layer (54) becomes a connecting wire between the battery sub-packs (1) by means of an appropriate laser scribing process, so as to achieve the effect of connecting the perovskite solar cell module in series to replace traditional busbars, thereby greatly reducing the use of the busbars, and effectively avoiding the problem of poor contact caused by using the busbars for series connection.

## Description

### TECHNICAL FIELD

The present disclosure relates to the technical field of solar cell structure and preparation, and in particular, to an internally series-connected perovskite solar cell module and a preparation method thereof.

### BACKGROUND

A connection of existing internally series-connected perovskite solar cell module typically requires the use of busbars. However, the busbars present certain drawbacks, mainly in the following aspects: 1) during an encapsulation process, placing the busbars can easily scratch a back electrode layer, potentially causing localized short circuits, which leads to a significant decrease in cell efficiency; 2) the introduction of busbars can also exacerbate an uneven stress distribution between a substrate and a backplane, reducing an overall strength of the module and weakening its impact resistance; and 3) from a cost perspective, the internally series-connected modules requires a larger number of busbars, increasing the probability of poor contact between the busbars and the back electrode layer.

### SUMMARY

The technical problem to be solved by the present disclosure is to provide an internally series-connected perovskite solar cell module and a preparation method thereof. Based on existing process technologies, a complete perovskite solar cell module is divided into several identical cell units by cutting. Through an appropriate laser scribing process, a back electrode layer of the perovskite solar cell module is used as a conductor to connect the cell units, thereby achieving a series connection effect for the perovskite solar cell module and replacing traditional busbars.

The present disclosure is realized as follows: an internally same-side series-connected perovskite solar cell module is provided. The internally same-side series-connected perovskite solar cell module comprises a plurality of sub-cell packs arranged longitudinally, and positions of positive polarities and negative polarities of two adjacent sub-cell packs are reversed, and each sub-cell pack includes a positive electrode tab, a negative electrode tab, and a plurality of cell units that are arranged horizontally, the positive electrode tab and the negative electrode tab are located at a front side and a rear side of each sub-cell pack, respectively, the plurality of cell units are located between the positive electrode tab and the negative electrode tab, and negative electrode tabs and positive electrode tabs between the two adjacent sub-cell packs are electrically connected only through an intermediate connection strap, respectively, and remaining portions between the two adjacent sub-cell packs are insulated from each other through an intermediate insulation strap; an internal structure of the positive electrode tab, the negative electrode tab, and the plurality of cell units includes a substrate, a front electrode layer, a light-absorbing layer, and a back electrode layer from bottom to top, and two adjacent cell units, the cell unit and the positive electrode tab, and the cell unit and the negative electrode tab, are respectively separated into sub-cell packs with an internal conductive connection by a scribing line group composed of a line P1, a line P2, and a line P3, wherein the P1 line scribes off the front electrode layer, the substrate at a bottom of a groove formed by the P1 line is exposed, the P2 line is close to the P1 line in a same group and scribes off the light-absorbing layer, the front electrode layer at a bottom of a groove formed by the P2 line is exposed, and the groove formed by the P2 line is filled with an electrically-conductive material, the P3 line is close to the P2 line in a same group and scribes off the back electrode layer and the light-absorbing layer at the same time, and the front electrode layer at a bottom of a groove formed by the P3 line is exposed; a positive electrode busbar is conductively laid on a surface of a back electrode layer of a positive electrode tab of a leftmost sub-cell pack, and a negative electrode busbar is conductively laid on a surface of a back electrode layer of a negative electrode tab of a rightmost sub-cell pack, and the positive electrode busbar and the negative electrode busbar are both located on a same side of the perovskite solar cell module.

The present disclosure is realized as follows: an internally opposite-side series-connected perovskite solar cell module is provided. The internally opposite-side series-connected perovskite solar cell module comprises a plurality of sub-cell packs arranged horizontally, and positions of positive polarities and negative polarities of two adjacent sub-cell packs are the same, and each sub-cell pack includes a positive electrode tab, a negative electrode tab, and a plurality of cell units that are arranged horizontally, the positive electrode tab and the negative electrode tab are located at a front side and a rear side of each sub-cell pack, respectively, the plurality of cell units are located between the positive electrode tab and the negative electrode tab, and negative electrode tabs and positive electrode tabs between two adjacent sub-cell packs are electrically connected only through a series connection strap, respectively, insulation grooves are arranged on two sides of the series connection strap to ensure insulation between the series connection strap and adjacent sub-cell packs; an internal structure of the positive electrode tab, the negative electrode tab, and the plurality of cell units includes a substrate, a front electrode layer, a light-absorbing layer, and a back electrode layer from bottom to top, and two adjacent cell units, the cell unit and the positive electrode tab, and the cell unit and the negative electrode tab, are respectively separated into sub-cell packs with an internal conductive connection by a scribing line group composed of a line P1, a line P2, and a line P3, wherein the P1 line scribes off the front electrode layer, the substrate at a bottom of a groove formed by the P1 line is exposed, the P2 line is close to the P1 line in a same group and scribes off the light-absorbing layer, the front electrode layer at a bottom of a groove formed by the P2 line is exposed, and the groove formed by the P2 line is filled with an electrically-conductive material, the P3 line is close to the P2 line in the same group and scribes off the back electrode layer and the light-absorbing layer at the same time, and the front electrode layer at a bottom of a groove formed by the P3 line is exposed; a positive electrode busbar is conductively laid on a surface of a back electrode layer of a positive electrode tab of a leftmost sub-cell pack, and a negative electrode busbar is conductively laid on a surface of a back electrode layer of a negative electrode tab of a rightmost sub-cell pack, and the positive electrode busbar and the negative electrode busbar are both located on a front side and a rear side of the perovskite solar cell module, respectively.

The present disclosure is realized as follows: an internally series-connected perovskite solar cell module is provided. The internally series-connected perovskite solar cell module comprises the internally same-side series-connected perovskite solar cell module and the internally opposite-side series-connected perovskite solar cell module.

The present disclosure is realized as follows: a method for preparing the internally same-side series-connected perovskite solar cell module is provided. The method comprises:
step 1, preparing the front electrode layer on the substrate, scribing the P1 line at a position of each cell unit on the front electrode layer, the P1 line scribing off the front electrode layer, and exposing the substrate at the bottom of the groove formed by the P1 line;
step 2, laying the light-absorbing layer on the front electrode layer and in the groove formed by the P1 line, scribing the P2 line on the light-absorbing layer close to the P1 line, and the P2 line scribing off the light-absorbing layer and exposing the front electrode layer at the bottom of the groove formed by the P2 line;
step 3, laying the back electrode layer on the light-absorbing layer and in the groove formed by the P2 line, scribing the P3 line on the back electrode layer close to the P2 line, and the P3 line scribing off the back electrode layer and light-absorbing layer, exposing the front electrode layer at the bottom of the groove formed by the P3 line, and obtaining the sub-cell pack composed of a positive electrode tab, a negative electrode tab, and a plurality of cell units that are arranged horizontally;
step 4, scribing the P4 line at a position of the intermediate insulation strap on the back electrode layer, and the P4 line exposing the substrate at a bottom of the intermediate insulation strap, and retaining a position of the intermediate connection strap on the back electrode layer;
step 5, isolating edges around a region where the sub-cell pack is located, a isolated region exposing the substrate at the bottom, and obtaining a plurality of sub-cell packs that are arranged horizontally and sequentially series-connected through the intermediate connection strap, with positions of positive electrode tabs and negative electrode tabs of two adjacent sub-cell packs being reversed; and
step 6, conductively laying the positive electrode busbar on the surface of the back electrode layer of the positive electrode tab of the leftmost sub-cell pack, and conductively laying the negative electrode busbar on the surface of the back electrode layer of the negative electrode tab of the rightmost sub-cell pack, and the positive electrode busbar and the negative electrode busbar being both located on the same side of the perovskite solar cell module.

The present disclosure is realized as follows: the method for preparing the internally opposite-side series-connected perovskite solar cell module is provided. The method comprises:
step 1, preparing the front electrode layer on the substrate, scribing the P1 line at a position of each cell unit on the front electrode layer, the P1 line scribing off the front electrode layer and exposing the substrate at the bottom of the groove formed by the P1 line;
step 2, laying the light-absorbing layer on the front electrode layer and in the groove formed by the P1 line, scribing the P2 line at a position of the light-absorbing layer close to the P1 line, and the P2 line scribing off the light-absorbing layer and exposing the front electrode layer at the bottom of the groove formed by the P2 line;
step 3, laying the back electrode layer on the light-absorbing layer and in the groove formed by the P2 line, scribing the P3 line at a position of the back electrode layer close to the P2 line, and the P3 line scribing off the back electrode layer and light-absorbing layer, exposing the front electrode layer at the bottom of the groove formed by the P3 line, and obtaining the sub-cell pack composed of a positive electrode tab, a negative electrode tab, and a plurality of cell units that are arranged horizontally;
step 4, scribing a P4 line at a position of the insulation groove on the back electrode layer, and the P4 line exposing the substrate at a bottom of the insulation groove and retaining a position of the series connection strap on the back electrode layer;
step 5, isolating edges around a region where the sub-cell pack is located, an isolated region exposing the substrate at the bottom, and obtaining a plurality of sub-cell packs that are arranged horizontally and sequentially series-connected through the series connection strap, with positions of positive polarities and negative polarities of two adjacent sub-cell packs being same; and
step 6, conductively laying the positive electrode busbar on the surface of the back electrode layer of the positive electrode tab of the leftmost sub-cell pack, and conductively laying the negative electrode busbar on the surface of the back electrode layer of the negative electrode tab of the rightmost sub-cell pack, and the positive electrode busbar and the negative electrode busbar being both located on the front side and the rear side of the perovskite solar cell module, respectively.

The present disclosure is realized as follows: a method for preparing the internally series-connected perovskite solar cell module is provided. The method comprises:
step A, preparing the front electrode layer on the substrate, scribing the P1 line at the position of each cell unit on the front electrode layer, the P1 line scribing off the front electrode layer and exposing the substrate at the bottom of the groove formed by the P1 line;
step B, laying the light-absorbing layer on the front electrode layer and in the groove formed by the P1 line, scribing the P2 line on the light-absorbing layer close to the P1 line, and the P2 line scribing off the light-absorbing layer and exposing the front electrode layer at the bottom of the groove formed by the P2 line;
step C, laying the back electrode layer on the light-absorbing layer and in the groove formed by the P2 line, scribing the P3 line on the back electrode layer close to the P2 line, the P3 line scribing off the back electrode layer and light-absorbing layer exposing the front electrode layer at the bottom of the groove formed by the P3 line, and obtaining the sub-cell pack composed of a positive electrode tab, a negative electrode tab, and a plurality of cell units that are arranged horizontally;
step D, dividing the back electrode layer into a region of internally same-side series-connected perovskite solar cell module and a region of internally opposite-side series-connected perovskite solar cell module, scribing a P4 line at a position of an intermediate insulation strap on a back electrode layer in the region of internally same-side series-connected perovskite solar cell module, and the P4 line exposing the substrate at a bottom of the intermediate insulation strap, and retaining a position of the intermediate connection strap on the back electrode layer; isolating edges around a region where the sub-cell pack is located, an isolated region exposing the substrate at the bottom, and obtaining a plurality of sub-cell packs that are arranged horizontally and sequentially series-connected through the intermediate connection strap, with positions of positive polarities and negative polarities of two adjacent sub-cell packs being reversed; scribing a P4' line at a position of an insulation groove on a back electrode layer in the region of internally opposite-side series-connected perovskite solar cell module, the P4' line exposing the substrate at a bottom of the insulation groove, and retaining a position of the series connection strap on the back electrode layer; isolating edges around a region where the sub-cell pack is located, an isolated region exposing the substrate at the bottom, and obtaining a plurality of sub-cell packs that are arranged horizontally and sequentially series-connected through the series connection strap, with positions of positive polarities and negative polarities of two adjacent sub-cell packs being same; and
step E, connecting a prepared internally same-side series-connected perovskite solar cell module and a prepared internally opposite-side series-connected perovskite solar cell module as needed, and conductively laying the positive electrode busbar on a surface of a back electrode layer of a positive electrode tab of one of the sub-cell pack, and conductively laying the negative electrode busbar on a surface of a back electrode layer of a negative electrode tab of another sub-cell pack.

Compared with the prior art, according to the internally series-connected perovskite solar cell module and a preparation method thereof of the present disclosure, the perovskite solar cell module comprises a plurality of sub-cell packs arranged longitudinally. Each sub-cell pack includes a positive electrode tab, a negative electrode tab, and a plurality of cell units arranged horizontally. The internal structure of the positive electrode tab, the negative electrode tab, and the plurality of cell units includes a substrate, a front electrode layer, a light-absorbing layer, and a back electrode layer from bottom to top. The present disclosure utilizes an appropriate laser scribing process to enable the back electrode layer to function as a conductor connecting the sub-cell packs, thereby achieving the series connection of the perovskite solar cell module. This approach replaces traditional busbars, allowing for internal series connection between the sub-cell packs of the perovskite solar cell module without the need for busbars, thereby avoiding issues such as scratching the thin film of the back electrode layer during encapsulation when realizing series connection through busbars, or even leading to internal short circuits within the perovskite solar cell module and reducing its power generation efficiency. At the same time, by utilizing the back electrode layer as a thin-film conductor to replace busbars for the connection between sub-cell packs in the perovskite solar cell module, the use of busbars is greatly reduced, effectively avoiding contact issues associated with series connections based on busbars. Furthermore, this method can be extended further to connect multiple small modules in series on the same module. Depending on the specific dimensions and arrangement, the series connection method described in the present disclosure can be applied. In certain specialized scenarios where there are requirements for the area and voltage of solar cells, the internal series connection within the module can effectively satisfy these demands, thereby opening up new market opportunities for the application of perovskite solar thin-film cells.

### BRIEF DESCRIPTION OF THE DRAWINGS

FIG. 1 is a schematic diagram illustrating an exemplary plan view of an internally same-side series-connected perovskite solar cell module according to a preferred embodiment of the present disclosure;
FIG. 2 is a schematic diagram illustrating an exemplary plan view of an internally opposite-side series-connected perovskite solar cell module according to a preferred embodiment of the present disclosure;
FIG. 3 is a schematic diagram illustrating a rotational section view in FIG. 1 along P-P;
FIG. 4 is a schematic diagram illustrating an enlarged view of a region M in FIG. 1; FIG. 5 is a schematic diagram illustrating an enlarged view of a region N in FIG. 2;
FIG. 6 is a schematic diagram illustrating Step 1 in Embodiment 4;
FIG. 7 is a schematic diagram illustrating Step 2 in Embodiment 4;
FIG. 8 is a schematic diagram illustrating Step 3 and Step 4 in Embodiment 4; and
FIG. 9 is a schematic diagram illustrating Step 3 and Step 4 in Embodiment 5.

### DETAILED DESCRIPTION

In order to make the technical problem to be solved, the technical solution, and the beneficial effect of the present disclosure clearer and more understandable, the following combines the accompanying drawings and the embodiment to further describe the present disclosure in detail. It should be understood that the specific embodiments described herein are only for explaining the present disclosure, and are not intended to limit the present disclosure.

### Embodiment 1

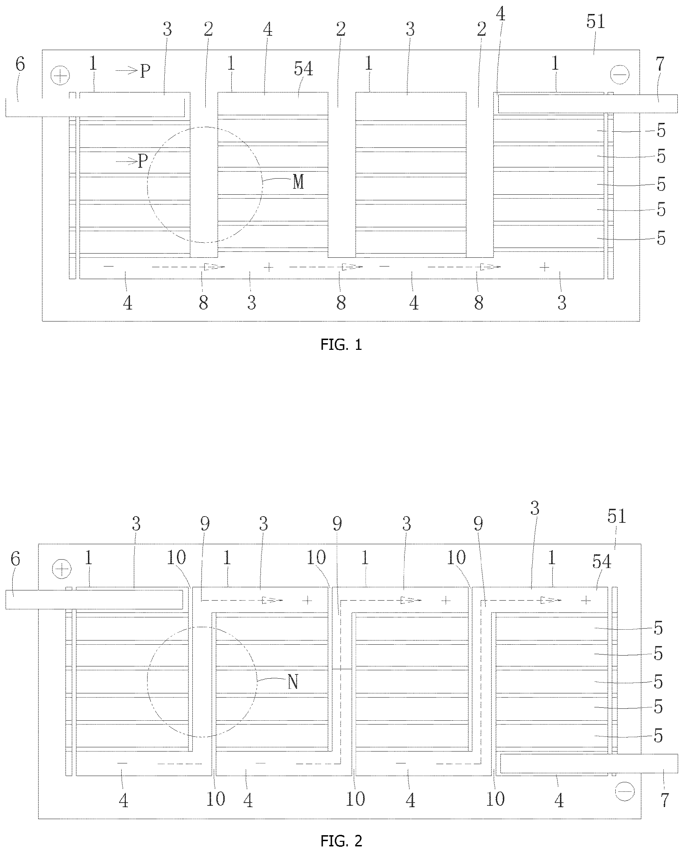

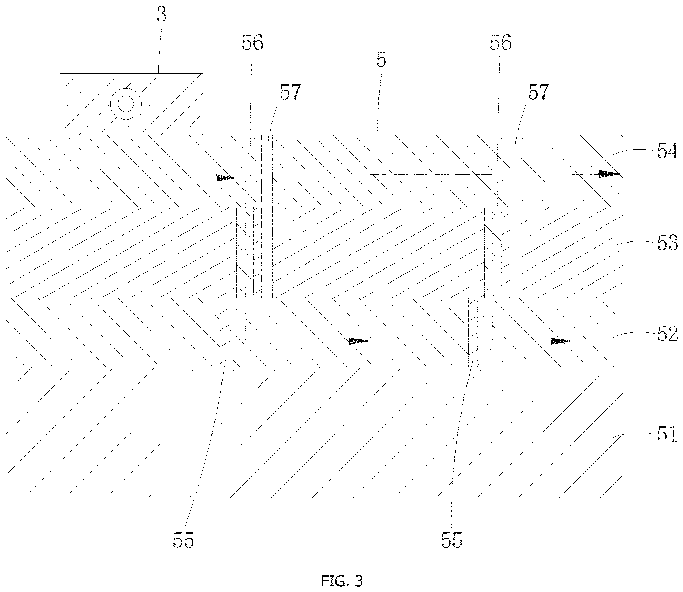

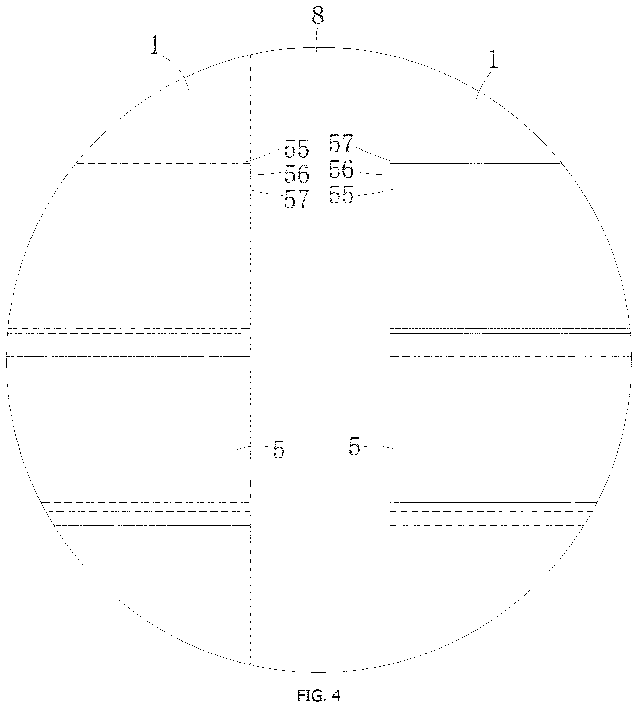

Referring to FIG. 1, FIG. 3, and FIG. 4, according to a first preferred embodiment of the present disclosure, an internally same-side series-connected perovskite solar cell module comprises a plurality of sub-cells packs 1 arranged longitudinally, and positions of positive polarities and negative polarities of two adjacent sub-cell packs are reversed. Dotted lines with arrows in FIG. 1 and FIG. 3 denote conduction directions of electrons within the perovskite solar cell module.

Each sub-cell pack 1 includes a positive electrode tab 3, a negative electrode tab 4, and a plurality of cell units 5 that are arranged horizontally. The positive electrode tab 3, the negative electrode tab 4, and the plurality of cell units 5 are internally series-connected to form the sub-cell pack 1. The positive electrode tab 3 and the negative electrode tab 4 are located at a front side and rear side of each sub-cell pack 1, respectively, and the plurality of cell units 5 are located between the positive electrode tab 3 and the negative electrode tab 4. The negative electrode tab 4 and the positive electrode tab 3 between two adjacent sub-cell packs 1 are electrically connected only through an intermediate connection strap 8, respectively, and remaining portions between the two adjacent sub-cell packs are insulated from each other through an intermediate insulation strap 2.

An internal structure of the positive electrode tab 3, the negative electrode tab 4, and the plurality of cell units 5 includes a substrate 51, a front electrode layer 52, a light-absorbing layer 53, and a back electrode layer 54 from bottom to top. Two adjacent cell units 5, and the cell unit 5 and the positive electrode tab 3, and the cell unit 5 and the negative electrode tab 4, are respectively separated into the sub-cell pack 1 with an internal conductive connection by a scribing line group composed of a line P1 55, a line P2 56, and a line P3 57. The P1 line 55 scribes off the front electrode layer 52, and the substrate at a bottom of a groove formed by the P1 line 55 is exposed. The P2 line 56 is close to the P1 line 55 in a same group and scribes off the light-absorbing layer 53, and the front electrode layer 52 at a bottom of a groove formed by the P2 line is exposed, and the groove formed by the P2 line 56 is filled with an electrically-conductive material. The P3 line 57 is close to the P2 line 56 and scribes off both the back electrode layer 54 and the light-absorbing layer 53, and the front electrode layer at a bottom of a groove formed by the P3 line 57 is exposed.

A positive electrode busbar 6 is conductively laid on a surface of the back electrode layer 54 of the positive electrode tab 3 of the leftmost sub-cell pack 1 at a starting end, and a negative electrode busbar 7 is conductively laid on a surface of the back electrode layer 54 of the negative electrode tab 4 of the rightmost sub-cell pack 1 at an ending end. The positive electrode busbar 6 and the negative electrode busbar 7 are both located on a same side of the perovskite solar cell module. The positive electrode busbar 6 and the negative electrode bus 7 are electrically connected to the back electrode layer 54 of the negative electrode tab 4 and the back electrode layer 54 of the positive electrode tab 3, respectively, of the sub-cell pack 1 in which they are located.

### Embodiment 2

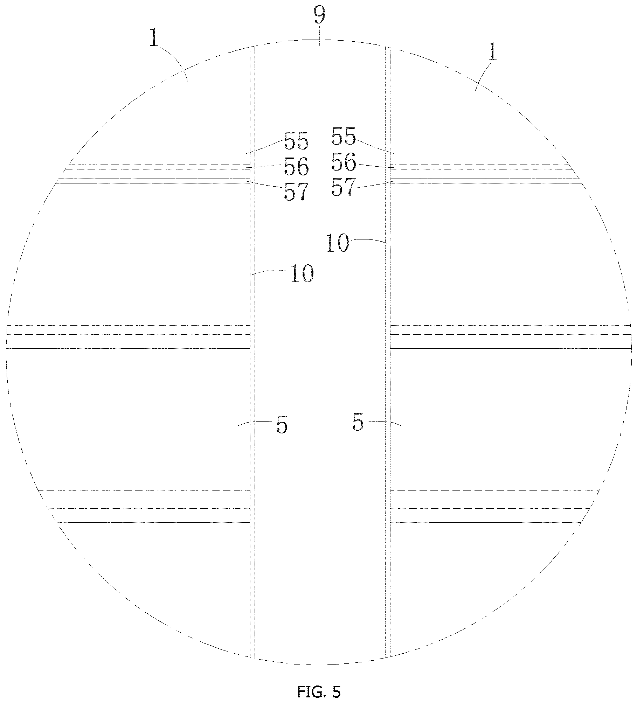

Referring to FIG. 2, FIG. 3 and FIG. 5, according to a first preferred embodiment of the present disclosure, an internally opposite-side series-connected perovskite solar cell module is provided, comprising a plurality of sub-cell packs 1 arranged horizontally, and positions of positive polarities and negative polarities of two adjacent sub-cell packs 1 are the same. Dotted lines with arrows in FIG. 2 and FIG. 3 denotes conduction directions of electrons within the perovskite solar cell module.

Each sub-cell pack 1 includes a positive electrode tab 3, a negative electrode tab 4, and a plurality of cell units 5 arranged horizontally. The positive electrode tab 3, the negative electrode tab 4, and the plurality of cell units 5 are internally series-connected to form the sub-cell pack 1. The positive electrode tab 3 and the negative electrode tab 4 are located at a front side and rear side of each sub-cell pack 1, respectively, and the plurality of cell units 5 are located between the positive electrode tab 3 and the negative electrode tab 4. Negative electrode tabs 4 and positive electrode tabs 3 between two adjacent sub-cell packs 1 are electrically connected only through a series connection strap 9, and insulation grooves 10 are arranged on two sides of the series connection strap 9, respectively, so as to insulate the series connection strap from adjacent sub-cell packs 1.

An internal structure of the positive electrode tab 3, the negative electrode tab 4, and the plurality of cell units 5 includes the substrate 51, the front electrode layer 52, the light-absorbing layer 53, and the back electrode layer 54 from bottom to up. Two adjacent cell units 5, the cell unit 5 and the positive electrode tab 3, and the cell unit 5 and the negative electrode tab 4, are respectively separated into sub-cell packs 1 with an internal conductive connection by a scribing line group composed of the line P1 55, the line P2 56, and the line P3 57. The P1 line 55 scribes off the front electrode layer 52, and the substrate 51 at a bottom of a groove formed by the P1 line 55 is exposed. The P2 line 56 is close to the P1 line 55 in a same group and scribes off the light-absorbing layer 53, and the front electrode layer 56 at a bottom of a groove formed by the P2 line 56 is exposed, and the groove formed by the P2 line 56 is filled with an electrically-conductive material. The P3 line 57 is close to the P2 line 56 in a same group and scribes off both the back electrode layer 54 and the light-absorbing layer 53, and the front electrode layer 52 at a bottom of a groove formed by the P3 line 57 is exposed.

The positive electrode busbar 6 is conductively laid on a surface of the back electrode layer 54 of the positive electrode tab 3 of the leftmost sub-cell pack 1 at a starting end, and a negative electrode busbar 7 is conductively laid on a surface of the back electrode layer 54 of the negative electrode tab 4 of the rightmost sub-cell pack 1 at an ending end. The positive electrode busbar 6 and the negative electrode busbar 7 are both located on a front side and rear side of the perovskite solar cell module, respectively. The positive electrode busbar 6 and the negative electrode busbar 7 are electrically connected to the back electrode layer 54 of the positive electrode tab 3 and the back electrode layer 54 of the negative electrode tab 4, respectively, of a sub-cell pack 1 in which they are located.

### Embodiment 3

According to an internally series-connected perovskite solar cell module of a first preferred embodiment of the present disclosure, an interior of the internally series-connected perovskite solar cell module comprises both an internally same-side series-connected perovskite solar cell module and an internally opposite-side series-connected perovskite solar cell module.

### Embodiment 4

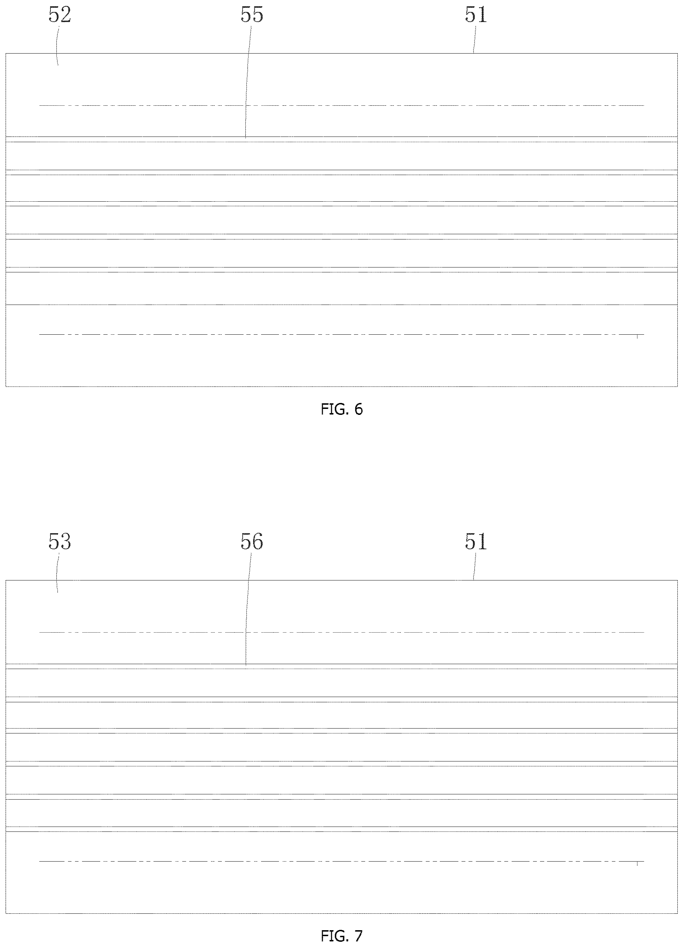

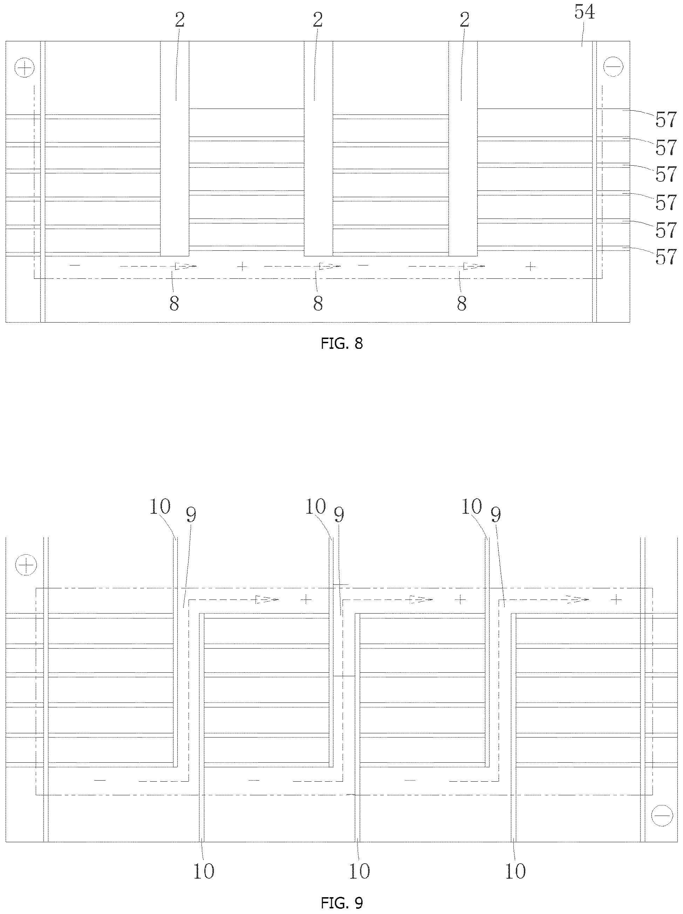

Referring to FIG. 1, FIG. 3, FIG. 4, and FIG. 6 to FIG. 8, a method for preparing an internally same-side series-connected perovskite solar cell module according to a first preferred embodiment of the present disclosure is provided. Dotted lines with arrows in FIG. 1, FIG. 3, and FIG. 8 denote conduction directions of electrons within the perovskite solar cell module. The method for preparing comprises following operations:
Step 1, the front electrode layer 52 is prepared on the substrate 51, and the P1 line 55 is scribed at a position of each cell unit 5 on the front electrode layer 52. The P1 line 55 scribes off the front electrode layer 52, and the substrate 51 at a bottom of a groove formed by the P1 line 55 is exposed. Double dotted lines in FIG. 6 to FIG. 8 denote a position of the sub-cell pack 1 of the perovskite solar cell module.
Step 2, the light-absorbing layer 53 is conductively laid on the front electrode layer 52 and in the groove formed by the P1 line 55. The P2 line 56 is scribed on the light-absorbing layer 53 close to the P1 line 55. The P2 line 56 scribes off the light-absorbing layer 53, and the front electrode layer 52 at a bottom of a groove formed by the P2 line 56 is exposed.
Step 3, the back electrode layer 54 is laid on the light-absorbing layer 53 and in the groove formed by the P2 line 56. The P3 line 57 is scribed on the back electrode layer 54 close to the P2 line 56, and the P3 line 57 scribes off the back electrode layer 54 and the light-absorbing layer 53, the front electrode layer 52 at a bottom of a groove formed by the P3 line 57 is exposed, and the sub-cell pack 1 composed of the positive electrode tab 3, the negative electrode tab 4, and the plurality of cell units 5 that are arranged horizontally is obtained.
Step 4, a P4 line 58 is scribed at a position of the intermediate insulation strap 2 on the back electrode layer 54. The P4 line 58 exposes the substrate 51 at a bottom of the intermediate insulation strap 2. A position of the intermediate connection strap 8 is retained on the back electrode layer 54.
Step 5, edges around a region where the sub-cell pack 1 is located are isolated, and the substrate 51 at a bottom of an isolated region is exposed. A plurality of sub-cell packs 1 arranged longitudinally and series-connected in sequence by the intermediate connection strap 8 is obtained. Positions of positive polarities and negative polarities of two adjacent sub-cell packs 1 are reversed, and negative electrode tabs 4 and positive electrode tabs 3 between two adjacent sub-cell packs 1 are electrically connected through the intermediate connection strap 8, respectively.
Step 6, the positive electrode busbar 6 is conductively laid on a surface of the back electrode layer 54 of the positive electrode tab 4 of the leftmost sub-cell pack 1 at a starting end, and the negative electrode busbar 7 is conductively laid on a surface of the back electrode layer 54 of the negative electrode tab 4 of the rightmost sub-cell pack 1 at an ending end. The positive electrode busbar 6 and the negative electrode busbar 7 are both located on a same side of the perovskite solar cell module.

Specifically, in two adjacent sub-cell packs 1, the P1 lines 55, the P2 lines 56, and the P3 lines 56 are arranged in a different order. In one of the sub-cell packs 1, the P1 line 55, the P2 line 56, and the P3 line 57 are arranged in a front-to-back order, and then in another sub-cell pack 1, the P1 line 55, the P2 line 56, and the P3 line 57 are arranged in a back-to-front order. The P2 lines 56 in two adjacent sub-cell packs 1 are co-lined.

### Embodiment 5

Referring to FIG. 2, FIG. 3, FIG. 6, FIG. 7, and FIG. 9, an internally opposite-side series-connected perovskite solar cell module according to a first preferred embodiment of the present disclosure is provided. Dotted lines with arrows in FIG. 2, FIG. 3, and FIG. 9 denote conduction directions of electrons within the perovskite solar cell module. A method for preparing an internally opposite-side series-connected perovskite solar cell module comprises following operations:
Step 1, which is same as Step 1 of Embodiment 4.
Step 2, which is same as Step 2 of Embodiment 4.
Step 3, which is same as Step 3 of Embodiment 4.
Step 4, which is same as Step 4 of Embodiment 4.
Step 5, edges around a region where the sub-cell pack 1 is located are isolated, the substrate 51 at a bottom of an isolated region is exposed, and a plurality of sub-cell packs 1 that are arranged horizontally and sequentially series-connected through the series connection strap is obtained. Positions of positive polarities and negative polarities of two adjacent sub-cell packs 1 are the same, and negative electrode tabs 4 and positive electrode tabs 3 between two adjacent sub-cell packs are connected through the series connection strap 9, respectively.
Step 6, the positive electrode busbar 6 is conductively laid on a surface of the back electrode layer 54 of the positive electrode tab 3 of the leftmost sub-cell pack 1 at an opening end, and the negative electrode busbar 7 is conductively laid on a surface of the back electrode layer 54 of the negative electrode tab 4 of the rightmost sub-cell pack 1 at an ending end. The positive electrode busbar 6 and the negative electrode busbar 7 are located on a front side and a rear side of the perovskite solar cell module, respectively.

Specifically, in two adjacent sub-cell packs 1, the P1 lines 55, the P2 lines 56, and the P3 lines 57 are arranged in a same order and the P1 lines 55, the P2 lines 56, and the P3 lines 57 in two sub-cell packs 1 are co-lined, respectively.

### Embodiment 6

An internally series-connected perovskite solar cell module according to a first preferred embodiment of the present disclosure comprises following operations:
Step A, which is same as Step 1 of Embodiment 4.
Step B, which is same as Step 2 of Embodiment 4.
Step C, which is same as Step 3 of Embodiment 4.
Step D, the back electrode layer is divided into a region of internally opposite-side series-connected perovskite solar cell module and a region of internally same-side series-connected perovskite solar cell module, the P4 line is scribed at a position of an intermediate insulation strap on a back electrode layer in the region of internally same-side series-connected perovskite solar cell module, and the P4 line exposes the substrate at a bottom of the intermediate insulation strap, and a position of the intermediate connection strap on the back electrode layer is retained; edges around a region where the sub-cell pack is located are isolated, a isolated region exposes the substrate at the bottom, and a plurality of sub-cell packs that are arranged horizontally and sequentially series-connected through the intermediate connection strap is obtained, with positions of positive polarities and negative polarities of two adjacent sub-cell packs being reversed; a P4' line is scribed at a position of an insulation groove on a back electrode layer in the region of internally opposite-side series-connected perovskite solar cell module, the P4' line exposes the substrate at a bottom of the insulation groove, and a position of the series connection strap on the back electrode layer is retained; edges around a region where the sub-cell pack is located are isolated, an isolated region exposes the substrate at the bottom, and a plurality of sub-cell packs that are arranged horizontally and sequentially series-connected through the series connection strap is obtained, with positions of positive polarities and negative polarities of two adjacent sub-cell packs being the same.
Step E, a prepared internally same-side series-connected perovskite solar cell module and a prepared internally opposite-side series-connected perovskite solar cell module are connected as needed, and a positive electrode busbar is conductively laid on a surface of a back electrode layer of a positive electrode tab of one of the sub-cell pack, and a negative electrode busbar is conductively laid on a surface of a back electrode layer of a negative electrode tab of another sub-cell pack.

The foregoing is only a preferred embodiment of the present disclosure, and is not intended to limit the present disclosure, and any modifications, equivalent substitutions, improvements, etc., made within the spirit and principles of the present disclosure shall be included in the scope of protection of the present disclosure.

## Claims

1. An internally same-side series-connected perovskite solar cell module, comprising a plurality of sub-cell packs arranged longitudinally, wherein positions of positive polarities and negative polarities of two adjacent sub-cell packs are reversed, and each sub-cell pack includes a positive electrode tab, a negative electrode tab, and a plurality of cell units that are arranged horizontally, the positive electrode tab and the negative electrode tab are located at a front side and a rear side of each sub-cell pack, respectively, the plurality of cell units are located between the positive electrode tab and the negative electrode tab, and negative electrode tab and positive electrode tab between the two adjacent sub-cell packs are electrically connected only through an intermediate connection strap, respectively, and remaining portions between the two adjacent sub-cell packs are isolated from each other through an intermediate insulation strap; an internal structure of the positive electrode tab, the negative electrode tab, and the plurality of cell units includes a substrate, a front electrode layer, a light-absorbing layer, and a back electrode layer from bottom to top, and two adjacent cell units, the cell unit and the positive electrode tab, and the cell unit and the negative electrode tab, are respectively separated into sub-cell packs with an internal conductive connection by a scribing line group composed of a line P1, a line P2, and a line P3, wherein the P1 line scribes off the front electrode layer, the substrate at a bottom of a groove formed by the P1 line is exposed, the P2 line is close to the P1 line in a same group and scribes off the light-absorbing layer, the front electrode layer at a bottom of a groove formed by the P2 line is exposed, and the groove formed by the P2 line is filled with an electrically-conductive material, the P3 line is close to the P2 line in a same group and scribes off the back electrode layer and the light-absorbing layer at the same time, and the front electrode layer at a bottom of a groove formed by the P3 line is exposed; a positive electrode busbar is conductively laid on a surface of a back electrode layer of a positive electrode tab of a leftmost sub-cell pack, and a negative electrode busbar is conductively laid on a surface of a back electrode layer of a negative electrode tab of a rightmost sub-cell pack, and the positive electrode busbar and the negative electrode busbar are both located on a same side of the perovskite solar cell module.

2. An internally opposite-side series-connected perovskite solar cell module , comprising a plurality of sub-cell packs arranged horizontally, wherein positions of positive polarities and negative polarities of two adjacent sub-cell packs are the same, and each sub-cell pack includes a positive electrode tab, a negative electrode tab, and a plurality of cell units that are arranged horizontally, the positive electrode tab and the negative electrode tab are located at a front side and a rear side of each sub-cell pack, respectively, the plurality of cell units are located between the positive electrode tab and the negative electrode tab, and negative electrode tabs and positive electrode tabs between two adjacent sub-cell packs are electrically connected only through a series connection strap, respectively, insulation grooves are arranged on two sides of the series connection strap to ensure insulation between the series connection strap and adjacent sub-cell packs; an internal structure of the positive electrode tab, the negative electrode tab, and the plurality of cell units includes a substrate, a front electrode layer, a light-absorbing layer, and a back electrode layer from bottom to top, and two adjacent cell units, the cell unit and the positive electrode tab, and the cell unit and the negative electrode tab, are respectively separated into sub-cell packs with an internal conductive connection by a scribing line group composed of a line P1, a line P2, and a line P3, wherein the P1 line scribes off the front electrode layer, the substrate at a bottom of a groove formed by the P1 line is exposed, the P2 line is close to the P1 line in a same group and scribes off the light-absorbing layer, the front electrode layer at a bottom of a groove formed by the P2 line is exposed, and the groove formed by the P2 line is filled with an electrically-conductive material, the P3 line is close to the P2 line in the same group and scribes off the back electrode layer and the light-absorbing layer at the same time, and the front electrode layer at a bottom of a groove formed by the P3 line is exposed; a positive electrode busbar is conductively laid on a surface of a back electrode layer of a positive electrode tab of a leftmost sub-cell pack, and a negative electrode busbar is conductively laid on a surface of a back electrode layer of a negative electrode tab of a rightmost sub-cell pack, and the positive electrode busbar and the negative electrode busbar are both located on a front side and a rear side of the perovskite solar cell module, respectively.

3. An internally series-connected perovskite solar cell module, comprising the internally same-side series-connected perovskite solar cell module of claim 1 and the internally opposite-side series-connected perovskite solar cell module of claim 2.

4. A method for preparing the internally same-side series-connected perovskite solar cell module of claim 1, comprising:
step 1, preparing the front electrode layer on the substrate, scribing the P1 line at a position of each cell unit on the front electrode layer, the P1 line scribing off the front electrode layer, and exposing the substrate at the bottom of the groove formed by the P1 line;
step 2, laying the light-absorbing layer on the front electrode layer and in the groove formed by the P1 line, scribing the P2 line on the light-absorbing layer close to the P1 line, and the P2 line scribing off the light-absorbing layer and exposing the front electrode layer at the bottom of the groove formed by the P2 line;
step 3, laying the back electrode layer on the light-absorbing layer and in the groove formed by the P2 line, scribing the P3 line on the back electrode layer close to the P2 line, and the P3 line scribing off the back electrode layer and light-absorbing layer, exposing the front electrode layer at the bottom of the groove formed by the P3 line, and obtaining the sub-cell pack composed of a positive electrode tab, a negative electrode tab, and a plurality of cell units that are arranged horizontally;
step 4, scribing the P4 line at a position of the intermediate insulation strap on the back electrode layer, and the P4 line exposing the substrate at a bottom of the intermediate insulation strap, and retaining a position of the intermediate connection strap on the back electrode layer;
step 5, isolating edges around a region where the sub-cell pack is located, a isolated region exposing the substrate at the bottom, and obtaining a plurality of sub-cell packs that are arranged horizontally and sequentially series-connected through the intermediate connection strap, with positions of positive electrode tabs and negative electrode tabs of two adjacent sub-cell packs being reversed; and
step 6, conductively laying the positive electrode busbar on the surface of the back electrode layer of the positive electrode tab of the leftmost sub-cell pack, and conductively laying the negative electrode busbar on the surface of the back electrode layer of the negative electrode tab of the rightmost sub-cell pack, and the positive electrode busbar and the negative electrode busbar being both located on the same side of the perovskite solar cell module.

5. The method for preparing the internally same-side series-connected perovskite solar cell module of claim 4, wherein in two adjacent sub-cell packs, the P1 line, the P2 line, and the P3 line are arranged in different orders, and in one of the sub-cell packs, the P1 line, the P2 line, and the P3 line are arranged in a front-to-back order, while in the other sub-cell pack, the P1 line, the P2 line, and the P3 line are arranged in a back-to-front order.

6. A method for preparing the internally opposite-side series-connected perovskite solar cell module of claim 2, comprising:
step 1, preparing the front electrode layer on the substrate, scribing the P1 line at a position of each cell unit on the front electrode layer, the P1 line scribing off the front electrode layer and exposing the substrate at the bottom of the groove formed by the P1 line;
step 2, laying the light-absorbing layer on the front electrode layer and in the groove formed by the P1 line, scribing the P2 line at a position of the light-absorbing layer close to the P1 line, and the P2 line scribing off the light-absorbing layer and exposing the front electrode layer at the bottom of the groove formed by the P2 line;
step 3, laying the back electrode layer on the light-absorbing layer and in the groove formed by the P2 line, scribing the P3 line at a position of the back electrode layer close to the P2 line, and the P3 line scribing off the back electrode layer and light-absorbing layer, exposing the front electrode layer at the bottom of the groove formed by the P3 line, and obtaining the sub-cell pack composed of a positive electrode tab, a negative electrode tab, and a plurality of cell units that are arranged horizontally;
step 4, scribing a P4 line at a position of the insulation groove on the back electrode layer, and the P4 line exposing the substrate at a bottom of the insulation groove and retaining a position of the series connection strap on the back electrode layer;
step 5, isolating edges around a region where the sub-cell pack is located, a isolated region exposing the substrate at the bottom, and obtaining a plurality of sub-cell packs that are arranged horizontally and sequentially series-connected through the series connection strap, with positions of positive polarities and negative polarities of two adjacent sub-cell packs being same; and
step 6, conductively laying the positive electrode busbar on the surface of the back electrode layer of the positive electrode tab of the leftmost sub-cell pack, and conductively laying the negative electrode busbar on the surface of the back electrode layer of the negative electrode tab of the rightmost sub-cell pack, and the positive electrode busbar and the negative electrode busbar being both located on the front side and the rear side of the perovskite solar cell module, respectively.

7. The method for preparing the internally opposite-side series-connected perovskite solar cell module of claim 6, wherein in two adjacent sub-cell packs, the P1 line, the P2 line, and the P3 line are arranged in a same order.

8. A method for preparing the internally series-connected perovskite solar cell module of claim 3, comprising:
step A, preparing the front electrode layer on the substrate, scribing the P1 line at the position of each cell unit on the front electrode layer, the P1 line scribing off the front electrode layer and exposing the substrate at the bottom of the groove formed by the P1 line;
step B, laying the light-absorbing layer on the front electrode layer and in the groove formed by the P1 line, scribing the P2 line on the light-absorbing layer close to the P1 line, and the P2 line scribing off the light-absorbing layer and exposing the front electrode layer at the bottom of the groove formed by the P2 line;
step C, laying the back electrode layer on the light-absorbing layer and in the groove formed by the P2 line, scribing the P3 line on the back electrode layer close to the P2 line, the P3 line scribing off the back electrode layer and light-absorbing layer exposing the front electrode layer at the bottom of the groove formed by the P3 line, and obtaining the sub-cell pack composed of a positive electrode tab, a negative electrode tab, and a plurality of cell units that are arranged horizontally;
step D, dividing the back electrode layer into a region of internally same-side series-connected perovskite solar cell module and a region of internally opposite-side series-connected perovskite solar cell module, scribing a P4 line at a position of an intermediate insulation strap on a back electrode layer in the region of internally same-side series-connected perovskite solar cell module, and the P4 line exposing the substrate at a bottom of the intermediate insulation strap, and retaining a position of the intermediate connection strap on the back electrode layer; isolating edges around a region where the sub-cell pack is located, a isolated region exposing the substrate at the bottom, and obtaining a plurality of sub-cell packs that are arranged horizontally and sequentially series-connected through the intermediate connection strap, with positions of positive polarities and negative polarities of two adjacent sub-cell packs being reversed; scribing a P4' line at a position of an insulation groove on a back electrode layer in the region of internally opposite-side series-connected perovskite solar cell module, the P4' line exposing the substrate at a bottom of the insulation groove, and retaining a position of the series connection strap on the back electrode layer; isolating edges around a region where the sub-cell pack is located, a isolated region exposing the substrate at the bottom, and obtaining a plurality of sub-cell packs that are arranged horizontally and sequentially series-connected through the series connection strap, with positions of positive polarities and negative polarities of two adjacent sub-cell packs being same; and
step E, connecting a prepared internally same-side series-connected perovskite solar cell module and a prepared internally opposite-side series-connected perovskite solar cell module as needed, and conductively laying the positive electrode busbar on a surface of a back electrode layer of a positive electrode tab of one of the sub-cell pack, and conductively laying the negative electrode busbar on a surface of a back electrode layer of a negative electrode tab of another sub-cell pack.
